(19) Europäisches Patentamt / European Patent Office / Office européen des brevets

(11) **EP 4 333 584 A1**

(12) **EUROPEAN PATENT APPLICATION**
published in accordance with Art. 153(4) EPC

(43) Date of publication:
06.03.2024 Bulletin 2024/10

(21) Application number: 22795691.9

(22) Date of filing: 22.04.2022

(51) International Patent Classification (IPC):
$H05K\ 9/00$ (2006.01)    $C08L\ 101/00$ (2006.01)

(52) Cooperative Patent Classification (CPC):
C08K 3/04; C08K 5/098; C08L 91/06;
C08L 101/00; H05K 9/00

(86) International application number:
PCT/JP2022/018608

(87) International publication number:
WO 2022/230778 (03.11.2022 Gazette 2022/44)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 27.04.2021 JP 2021074629

(71) Applicants:
• artience Co., Ltd.
Chuo-ku
Tokyo 104-0031 (JP)
• TOYOCOLOR CO., LTD.
Tokyo, 104-0031 (JP)

(72) Inventors:
• MAJIMA Yuki
Tokyo 104-0031 (JP)
• YANAGISAWA Makoto
Tokyo 104-0031 (JP)
• SAITO Moe
Tokyo 104-0031 (JP)
• MASUDA Keisuke
Tokyo 104-0031 (JP)

(74) Representative: Pfenning, Meinig & Partner mbB
Patent- und Rechtsanwälte
Theresienhöhe 11a
80339 München (DE)

(54) **THERMOPLASTIC RESIN COMPOSITION TO BE USED IN ELECTROMAGNETIC WAVE ABSORBER, AND MOLDED ARTICLE**

(57) Provided is a thermoplastic resin composition capable of obtaining uniform electromagnetic absorption performance with no in-plane variation in a molded article thereof as a result of the fluidity being favorable in addition to the reflection loss and transmission loss being high. A thermoplastic resin composition according to the present disclosure which is to be used in an electromagnetic wave absorber and contains a thermoplastic resin (A) and carbon nanotubes (B), wherein the carbon nanotubes (B) satisfy formulas (1) and (2), and a sheet having a thickness of $100\,\mu m$ and formed from the thermoplastic resin composition has a sheet surface maximum height Sz of $5\,\mu m$ or less when measured according to ISO 25178. (1) The full width at half maximum of the diffraction peak of the (002) plane in powder X-ray diffraction analysis is 2.0-6.0°. (2) The ratio (G/D) of the maximum peak intensity G in a 1,560-1,600 $cm^{-1}$ range in a Raman spectrum to the maximum peak intensity D in a 1,310-1,350 $cm^{-1}$ range therein is 0.5-2.0.

EP 4 333 584 A1

## Description

[Technical Field]

The present disclosure relates to a thermoplastic resin composition to be used in an electromagnetic wave absorber and a molded article.

[Background Art]

Plastics are used in a wide range of fields such as electrical/electronic device parts, automobile parts, medical parts, and food containers because they are easy to mold, and plastic molded products can be colored in order to improve decorativeness and impart functionality. Particularly, in the field of automobiles, molded articles colored for the purpose of electromagnetic absorption are distributed as functionality-imparted products.

Electromagnetic waves are emitted from communication devices such as radios, televisions, and wireless communication devices, and in addition, electronic devices such as mobile phones and computers, which have increased rapidly due to the recent progress in information technology, also emit electromagnetic waves. Conventionally, as one method of avoiding malfunctions caused by electromagnetic waves in electronic devices, communication devices and the like, an electromagnetic wave absorber that efficiently absorbs electromagnetic waves and converts the absorbed electromagnetic waves into thermal energy is installed near or far from the electromagnetic wave generating part.

As an example in which an electromagnetic wave absorber is used by being installed far from the electromagnetic wave generating part, for example, an automatic toll collection system (electronic toll collection system (ETC)) for highways is exemplified. The ETC is a system that uses microwaves with a frequency of 5.8 GHz and exchanges charging information between an antenna on a roadside unit provided in a tollgate and an antenna on the side of a vehicle-mounted device when a vehicle passes through an exit of a tollgate on a highway. In the tollgate into which this ETC system is introduced, communication errors may occur due to microwaves emitted from the antenna that are reflected by the roof of the tollgate, leakage of unnecessary electromagnetic waves from adjacent ETC lanes or the like. Therefore, communication errors are reduced by installing the electromagnetic wave absorber between the tollgate roof and the ETC lane.

In addition, in recent years, in the field of automobiles, millimeter-wave radars have been used for automatic driving and collision prevention of vehicles, and in many cases, millimeter-wave radar devices are installed inside automobiles. Millimeter waves are electromagnetic waves with a wavelength of 1 to 10 mm and a frequency of 30 to 300 GHz among electromagnetic waves, and are also currently used for in-vehicle radars, full-body scanners that see through clothes for security checks in airports and the like, and video transmission from monitoring cameras on platforms during one-man train driving. The millimeter-wave radar device is a device that can emit millimeter waves and receive waves that bounce back to recognize obstacles, and due to its long detection distance, and resistance to obstruction by sunlight, rain, and fog, the device is now used in an automatic driving technique for automobiles. In the case of automobile sensors, the millimeter-wave radar device can transmit and receive millimeter waves from an antenna and detect a relative distance and a relative speed with respect to obstacles.

The transmitting/receiving antenna of the above millimeter-wave radar device receives waves that are reflected by the road surface and the like other than target obstacles, and the detection accuracy of the device may decrease. In order to address such problems, in the millimeter-wave radar device, as a shielding member that shields electromagnetic waves, an electromagnetic wave absorber is provided between an antenna and a control circuit.

As electromagnetic absorbing materials in the millimeter wave band, which constitute the electromagnetic wave absorber, carbon-based, metal carbon-based, and magnetic substance-based materials are known, and particularly, carbon nanotubes (CNT) are known as carbon-based materials. Since resin compositions containing carbon nanotubes have high conductivity, they are used for parts that require conductivity in the fields of automobiles, home appliances, and building members (Patent Literature 1) or used for electromagnetic wave absorbers that utilize electromagnetic wave properties (Patent Literature 2 and 3). However, molded articles using these resin compositions do not have sufficient electromagnetic absorption performance regarding reflection loss and transmission loss of electromagnetic waves required to sufficiently protect the radar from the surrounding environment and prevent interference with signal transmission of the radar, and there is room for improvement. In addition, since carbon nanotubes, which are used for electromagnetic wave absorbers, have a thickening effect, there are problems that the fluidity of the resin composition decreases, resulting in poor distribution, and it is difficult to achieve uniform electromagnetic absorption performance.

[Citation List]

[Patent Literature]

2

[Patent Literature 1]
Japanese Patent Laid-Open No. 2016-108524
[Patent Literature 2]
Published Japanese Translation No. 2017-512847 of the PCT International Publication
[Patent Literature 3]
Published Japanese Translation No. 2016-504471 of the PCT International Publication

[Summary of Invention]

[Technical Problem]

An objective of the present disclosure is to provide a thermoplastic resin composition having a high reflection loss and transmission loss and also having favorable fluidity, and which allows uniform electromagnetic absorption performance to be obtained with no in-plane variation in a molded article, and a molded article formed from the thermoplastic resin composition and having excellent electromagnetic absorption performance.

[Solution to Problem]

Specifically, the present disclosure is a thermoplastic resin composition which is to be used in an electromagnetic wave absorber and contains a thermoplastic resin (A) and carbon nanotubes (B), wherein the carbon nanotubes (B) satisfy the following (1) and (2), and wherein a sheet having a thickness of 100 $\mu$m and formed from the thermoplastic resin composition has a sheet surface maximum height Sz of 5 $\mu$m or less, which is measured according to ISO 25178:

(1) the full width at half maximum of the diffraction peak of the (002) plane in powder X-ray diffraction analysis is 2.0° to 6.0°.
(2) the ratio (G/D ratio) of the maximum peak intensity G in a range of 1,560 to 1,600 cm$^{-1}$ and the maximum peak intensity D in a range of 1,310 to 1,350 cm$^{-1}$ in a Raman spectrum is 0.5 to 2.0.

[Advantageous Effects of Invention]

According to the present disclosure, it is possible to provide a thermoplastic resin composition having a high reflection loss and transmission loss and also having favorable fluidity, and which allows uniform electromagnetic absorption performance to be obtained with no in-plane variation in a molded article, and a molded article formed from the thermoplastic resin composition and having excellent electromagnetic absorption performance. Particularly, it is possible to provide a molded article that can be suitably used as a millimeter-wave absorber because it has excellent reflection loss and transmission loss in a specific frequency band of 60 to 90 GHz.

[Description of Embodiments]

Hereinafter, the present disclosure will be described in detail. Here, in this specification, "film" and "sheet" are synonymous. In addition, in this specification, a numerical value range specified using "to" means that the numerical values stated before and after "to" are included as a lower limit value and an upper limit value. In addition, carbon nanotubes may be expressed as CNT. In addition, unless otherwise noted, various components shown in this specification may be used alone independently or two or more thereof may be used in combination.

<<Thermoplastic resin composition to be used in electromagnetic wave absorber>>

A thermoplastic resin composition of the present disclosure is used to form an electromagnetic wave absorber. The thermoplastic resin composition contains a thermoplastic resin (A) and carbon nanotubes (B), the carbon nanotubes (B) satisfy the following (1) and (2), and a sheet having a thickness of 100 $\mu$m and formed from the thermoplastic resin composition has a sheet surface maximum height Sz of 5 $\mu$m or less, which is measured according to ISO 25178.

(1) the full width at half maximum of the diffraction peak of the (002) plane in powder X-ray diffraction analysis is 2.0° to 6.0°.
(2) the ratio (G/D ratio) of the maximum peak intensity G in a range of 1,560 to 1,600 cm$^{-1}$ and the maximum peak intensity D in a range of 1,310 to 1,350 cm$^{-1}$ in a Raman spectrum is 0.5 to 2.0.

The sheet having a thickness of 100 $\mu$m and formed from the thermoplastic resin composition has a maximum surface height Sz of 5 $\mu$m or less. Accordingly, it is possible to form a molded article with a high reflection loss and transmission loss and with no in-plane variation and having excellent electromagnetic absorption performance. The maximum height Sz is preferably as small as possible, and is more preferably 5 $\mu$m or less, and still more preferably 4 $\mu$m or less.

In the thermoplastic resin composition of the present disclosure, when the carbon nanotubes (B) having specific ranges of the full width at half maximum of the X-ray diffraction peak and the G/D ratio in the Raman spectrum are used, and the sheet surface maximum height Sz is within the above range, the resin composition can have excellent electromagnetic absorption performance and also have excellent resin composition fluidity. The sheet surface maximum height Sz varies greatly depending on dispersibility of the carbon nanotubes. In order for the sheet surface maximum height Sz to be within the above range, in addition to using the carbon nanotubes (B) and the thermoplastic resin (A) of the present disclosure as the carbon nanotubes (B) to be used, the maximum height can be controlled by highly dispersing carbon nanotubes depending on dispersion conditions when the resin is melt-kneaded in order to form a molded article. If the full width at half maximum of the carbon nanotubes is larger than 6.0°, the carbon nanotubes become closer to single-wall carbon nanotubes. When the carbon nanotubes become closer to single-wall carbon nanotubes, the carbon nanotubes have a larger specific surface area and higher crystallinity, and the cohesive force is very strong and the dispersibility in the resin is poor. Therefore, when carbon nanotubes (B) having a full width at half maximum of 2.0° to 6.0° are used, the maximum height Sz can be controlled to be 5 $\mu$m or less. When the carbon nanotubes (B) of the present disclosure are used, even if they are highly dispersed, the resin composition maintains fluidity, the surface roughness of the sheet is also smooth, and electromagnetic absorption properties can be made excellent.

A method of forming a sheet for measuring the sheet surface maximum height Sz is not limited as long as a sheet having a thickness of 100 $\mu$m can be formed. For example, a thermoplastic resin composition containing a thermoplastic resin (A) and carbon nanotubes (B) is heated and melted, and a sheet can be molded using a T-die molding machine. Specifically, for example, a sheet having a thickness of 100 $\mu$m can be produced using a T-die molding machine at a temperature 30°C higher than the melting point of the thermoplastic resin (A) used in the resin composition.

The sheet surface maximum height Sz is a parameter obtained by three-dimensionally expanding the maximum height Rz, which is a two-dimensional roughness parameter, and indicates a distance from the highest point to the lowest point on the measurement surface. The maximum height Sz can be measured according to ISO 25178. Here, when the cross section of a certain surface is extracted, and the roughness is discussed, Sz and Rz can be regarded as synonymous.

Specifically, for example, using the produced sheet having a thickness of 100 $\mu$m, the maximum height Sz ($\mu$m) when the measurement length is 2.5 mm×2.5 mm and the robust Gaussian filter is 0.08 mm is obtained using TalySurf CCI MP-HS (commercially available from Taylor/Hobson).

In addition, the mass flow rate (MFR) in the thermoplastic resin composition to be used in an electromagnetic wave absorber of the present disclosure is preferably 0.1 to 30 g/10 minutes and more preferably 5 to 30 g/10 minutes. When the MFR is within the above range, the carbon nanotubes are uniformly distributed in the molded article during molding, and uniform electromagnetic absorption performance is obtained in the molded article. Here, the MFR in the present disclosure can be measured according to JIS (Japanese Industrial Standards) K-7210.

<Thermoplastic resin (A)>

The thermoplastic resin (A) is not particularly limited as long as it is a resin that can be molded by heating and melting. Examples of thermoplastic resins (A) include polyolefin-based resins such as polyethylene resin (PE) and polypropylene resin (PP), and polystyrene-based resin (PS), polyphenylene ether-based resin, polyethylene terephthalate resin (PET), polybutylene terephthalate resin (PBT), acrylonitrile-butadiene-styrene copolymer resin (ABS), polycarbonate resin (PC), polyamide resin (PA), polyacetal resin (POM), polyester-based resin, polyvinyl chloride resin, acrylic resin, polyetherimide resin (PEI), polyphenylene sulfide resin, polyurethane resin (PU), and liquid silicone rubber (LSR). In consideration of versatility and mechanical properties, polyethylene resin (PE), polypropylene resin (PP), acrylonitrile-butadienestyrene copolymer resin (ABS), polycarbonate resin (PC), polyamide resin (PA), polyester-based resin and the like are preferable.

The weight average molecular weight of the thermoplastic resin (A) is preferably 1,000 to 900,000 and more preferably 2,000 to 500,000 in consideration of versatility and mechanical properties. Particularly, as the thermoplastic resin (A), it is preferable to use a thermoplastic resin (A1) having a weight average molecular weight of 50,000 or more and a thermoplastic resin (A2) having a weight average molecular weight of less than 50,000 in combination. Therefore, when the carbon nanotubes (B) and the thermoplastic resin (A) are melt-kneaded, the wettability of the carbon nanotubes is improved, the aggregated carbon nanotubes can be loosened and highly dispersed, and thus the electromagnetic absorption performance can be further improved. Here, the number average molecular weight is a value measured through gel permeation chromatography (GPC method) (a measured value obtained using polystyrene as a standard substance and tetrahydrofuran as an eluent).

The weight ratio (A1):(A2) of the thermoplastic resin (A1) and the thermoplastic resin (A2) is preferably 99:1 to 50:50 and more preferably 90:10 to 50:50. When the ratio is within the above range, this is preferable because the thermoplastic resin (A2) can improve the wettability of the carbon nanotubes (B), and improve the dispersibility of the carbon nanotubes (B) in the thermoplastic resin (A1) which is a diluent resin.

<Carbon nanotubes (B)>

The carbon nanotubes (B) satisfy the following (1) and (2).

(1) the full width at half maximum of the diffraction peak of the (002) plane in powder X-ray diffraction analysis is 2.0° to 6.0°.
(2) the ratio (G/D ratio) of the maximum peak intensity G in a range of 1,560 to 1,600 cm$^{-1}$ and the maximum peak intensity D in a range of 1,310 to 1,350 cm$^{-1}$ in a Raman spectrum is 0.5 to 2.0 or less.

Carbon nanotubes have a structure in which a graphene sheet is rolled into a cylindrical shape, and when the carbon nanotubes are composed of a single layer, they called single-wall carbon nanotubes (SWCNT), and when the carbon nanotubes are composed of multiple layers, they called multi-wall carbon nanotubes (MWCNT), and individual carbon nanotubes can be confirmed under an electron microscope or the like. For carbon nanotubes, carbon nanotube fibers are primarily aggregated and intertwined to form bundled primary aggregates, or primary aggregates may be aggregated to form secondary or higher aggregates.

[Full width at half maximum of X-ray diffraction peak]

The full width at half maximum of the diffraction peak of the (002) plane of the carbon nanotubes (B) is 2.0° to 6.0°, and more preferably 2.0° to 5.0°. Within the above range, the thermoplastic resin composition to be used in an electromagnetic wave absorber has favorable electromagnetic absorption. If the full width at half maximum is 2.0° or more, the number of carbon nanotube layers is reduced, the amorphous part of the carbon nanotubes is reduced, the crystallinity increases, and thus the electromagnetic absorption performance of the carbon nanotubes is improved. In addition, if the full width at half maximum is 6.0° or less, the carbon nanotubes have a large specific surface area and high crystallinity while a cohesive force between the carbon nanotubes is reduced, and thus the electromagnetic absorption performance can be improved while maintaining high dispersibility.

The (002) plane of the carbon nanotubes (B) is detected at a position at which $2\theta$ is $25°\pm2°$ and varies depending on the inter-plane distance of the carbon hexagonal network planes. If the peak position is on a wider angle side, the distance between carbon hexagonal network planes is closer, which indicates that the graphite-like regularity of the structure is higher. In addition, it indicates that, if the peak becomes sharper (if the half-value width is smaller), the crystallite size is larger, and the crystal structure is developed.

The full width at half maximum of the carbon nanotubes (B) is obtained as follows. First, the carbon nanotubes (B) are packed in a predetermined sample holder so that the surface is flat, set in a powder X-ray diffraction analysis device, and measured while changing the emission angle of an X-ray source from 5° to 80°. As the X-ray source, for example, CuK$\alpha$ rays are used. The step width is 0.010°, and the measurement time is 1.0 seconds. The carbon nanotubes (B) can be evaluated by reading the diffraction angle $2\theta$ at which a peak appears in this case. In graphite, a peak is usually detected in the vicinity of $2\theta$ of 26°, and it is known that this peak is due to interlayer diffraction. Since the carbon nanotubes (B) also have a graphite structure, a peak due to graphite interlayer diffraction is detected in this vicinity. However, since the carbon nanotubes have a cylindrical structure, the value differs from that of graphite. When a peak appears at a position at which the value $2\theta$ is $25°\pm2°$, it can be determined that a composition having a multi-layer structure rather than a single-layer structure is contained. Since the peak appearing at this position is a peak due to interlayer diffraction of the multi-layer structure, it is possible to determine the number of layers of carbon nanotubes (B). Since single-wall carbon nanotubes have only one layer, no peak appears at a position of $25°\pm2°$ with only the single-wall carbon nanotubes. However, single-wall carbon nanotubes are not 100% single-wall carbon nanotubes, and when multi-wall carbon nanotubes are mixed, a peak may appear at a position at which $2\theta$ is $25°\pm2°$.

In the carbon nanotubes (B) of the present embodiment, a peak appears at a position at which $2\theta$ is $25°\pm2°$. In addition, a layer structure can also be analyzed from the full width at half maximum of a peak at $25°\pm2°$ detected by powder X-ray diffraction analysis. That is, it is considered that, if the full width at half maximum of this peak is smaller, the number of layers of carbon nanotubes (B) is larger. On the other hand, it is considered that, if the full width at half maximum of this peak is larger, the number of carbon nanotube layers is smaller.

When the carbon nanotubes (B) of the present embodiment are subjected to powder X-ray diffraction analysis, a peak is present at a diffraction angle $2\theta=25°\pm2°$, and the full width at half maximum of the peak of the (002) plane is 2.0° to 6.0°.

[G/D ratio in Raman spectrum]

The carbon nanotubes (B) have a G/D ratio of 0.5 to 2.0 when the maximum peak intensity in a range of 1,560 to 1,600 $cm^{-1}$ is G and the maximum peak intensity in a range of 1,310 to 1,350 $cm^{-1}$ is D in a Raman spectrum. The G/D ratio is particularly preferably 0.5 to 1.0. In the Raman spectrum, the Raman shift appearing near 1,590 $cm^{-1}$ is called a G band derived from graphite, and the Raman shift appearing near 1,350 $cm^{-1}$ is called a D band derived from defects in amorphous carbon and graphite. Carbon nanotubes with a higher G/D ratio have a higher degree of graphitization. If the G/D ratio is less than 0.5, the amount of amorphous carbon nanotubes increases, and the electromagnetic absorption performance of the carbon nanotubes decreases, and if the G/D ratio is more than 2.0, the crystallinity of the carbon nanotubes increases, the dispersibility in the resin decreases, and as a result, the electromagnetic absorption performance decreases.

A powder sample is provided in a microscopic laser Raman spectrophotometer (NRS-3100, commercially available from JASCO Corporation) and measurement is performed using a laser wavelength of 532 nm, and thus the G/D ratio can be calculated from an integrated value of peaks in a G band derived from a graphite structure near 1,590 $cm^{-1}$ and a D band derived from a structural defect near 1,350 $cm^{-1}$.

[Volume resistivity]

In addition, the volume resistivity of the carbon nanotubes (B) is preferably $1.0 \times 10^{-3}$ to $1.5 \times 10^{-2}$ $\Omega\cdot cm$, and more preferably $1.0 \times 10^{-3}$ to $1.0 \times 10^{-2}$ Q.cm. If the volume resistivity of the carbon nanotubes (B) is within the above range, electromagnetic absorption becomes better. If the volume resistivity of the carbon nanotubes (B) is $1.0 \times 10^{-3}$ $\Omega\cdot cm$ or more, this is preferable because the conductivity of the resin composition increases while reflection of electromagnetic waves is reduced so that the transmission loss can be improved while a high reflection loss is maintained. On the other hand, if the volume resistivity of the carbon nanotubes (B) is $1.0 \times 10^{-2}$ Q.cm or less, this is preferable because electromagnetic waves are easily absorbed and the transmission loss is improved. The volume resistivity of the carbon nanotubes (B) can be measured using a powder resistivity measuring device (commercially available from Mitsubishi Chemical Analytech Co., Ltd.: Loresta GP powder resistivity measuring system MCP-PD-51).

[Bulk density]

The bulk density of the carbon nanotubes (B) is preferably 0.005 to 0.5 g/mL. When carbon nanotubes having a bulk density within the above range are used, the dispersibility in the thermoplastic resin (A) becomes favorable, and the productivity during kneading is excellent.

Here, the bulk density here is measured by using a Scott volumeter (commercially available from Tsutsui Scientific Instruments Co., Ltd.) as a measuring device, pouring a carbon nanotube powder into a straight cylindrical container from the top of the measuring device, and measuring a mass of a sample with a certain volume that has been scraped off when it forms a heap, and is a ratio of the mass and the container volume, and is a value calculated based on the following formula [1].

Formula [1] bulk density (g/mL)=

(mass (g) of carbon nanotubes with a certain volume that have been scraped

off)÷(container volume (mL))

The carbon nanotubes (B) may be single-wall carbon nanotubes or multi-wall carbon nanotubes wound in two or more layers, or a mixture thereof, and multi-wall carbon nanotubes are preferable in terms of cost and strength. In addition, carbon nanotubes having side walls with an amorphous structure instead of a graphite structure may be used as the carbon nanotubes.

The carbon nanotubes (B) can generally be produced by a laser ablation method, an arc discharge method, a chemical vapor deposition method (CVD), a combustion method or the like, and carbon nanotubes may be produced by any method. Particularly, the CVD method is a method in which, usually, at a high temperature of 400 to 1.000°C, catalyst fine particles in which metal catalysts such as iron and nickel are supported on carriers such as silica, alumina, magnesium oxide, titanium oxide, silicate, diatomaceous earth, alumina silica, silica titania, and zeolite are brought into contact with a raw carbon-containing gas, and thus a large amount of carbon nanotubes can be produced cheaply, and are preferable as carbon nanotubes used in the present disclosure.

<Wax and aliphatic metal salt>

In the thermoplastic resin composition of the present disclosure, at least one of a wax and an aliphatic metal salt can be additionally used. If a wax or an aliphatic metal salt is used, when the carbon nanotubes (B) and the thermoplastic resin (A) are melt-kneaded, the wettability of the carbon nanotubes is improved, the aggregated carbon nanotubes can be loosened and highly dispersed and thus the electromagnetic absorption performance can be further improved.

Examples of waxes include natural waxes, semi-synthetic waxes, and synthetic waxes. Examples of natural waxes include paraffin wax and montan wax. Examples of semi-synthetic waxes include ethylene-bis-steramide and amide waxes. Examples of synthetic waxes include polyethylene wax and polypropylene wax.

The number average molecular weight of the wax is preferably 1,000 to 30,000 and more preferably 1,000 to 10,000. If the number average molecular weight is 1,000 or more, this is preferable because the wettability of the carbon nanotubes is improved when the carbon nanotubes (B) and the thermoplastic resin (A) are kneaded and the carbon nanotubes can be loosened. If the number average molecular weight is 30,000 or less, this is preferable because the melt viscosity becomes moderate during kneading, kneading can be performed with a strong shear force, the aggregated carbon nanotubes can be loosened while re-aggregation of the carbon nanotubes is inhibited, and thus the carbon nanotubes are highly dispersed, and the electromagnetic absorption performance is improved.

Here, the number average molecular weight is a value measured by gel permeation chromatography (GPC method) (a measured value obtained using polystyrene as a standard substance and tetrahydrofuran as an eluent).

Examples of aliphatic metal salts include metal salts of linear aliphatic monocarboxylic acids. Examples of linear aliphatic monocarboxylic acids include lauric acid, palmitic acid, stearic acid, oleic acid, and ricinoleic acid. Examples of metals include calcium, zinc, magnesium, barium, and aluminum.

The content of the wax and the aliphatic metal salt with respect to 100 parts by mass of the thermoplastic resin (A) is preferably 0.1 to 30 parts by mass and more preferably 0.1 to 15 parts by mass. If the content is 0.1 parts by mass or more, the dispersibility of the carbon nanotubes can be further improved, and if the content is 30 parts by mass or less, this is preferable because optimal fluidity can be maintained, and thus an appropriate shear force can be added to the carbon nanotubes during kneading so that the dispersibility is further improved.

In the thermoplastic resin composition to be used in an electromagnetic wave absorber, as necessary, a weather stabilizer, an antistatic agent, a dye, a pigment, a coupling agent, a crystal nucleating agent, a resin filler and the like can be used. Here, as the electromagnetic absorbing material, as long as the effects of the present disclosure are not impaired, carbon nanotubes other than the carbon nanotubes (B), carbon black and the like may be contained. In consideration of electromagnetic absorption performance, the content of the carbon nanotubes (B) in 100 mass% of the electromagnetic absorbing material is preferably larger, more preferably 50 to 100 mass%, still more preferably 70 to 100 mass%, and yet more preferably 90 to 100 mass%. That is, the content of the electromagnetic absorbing material other than the carbon nanotubes (B) is preferably 10 mass% or less and more preferably 5 mass% or less.

When the dispersibility of the carbon nanotubes is poor, a high addition amount is required to achieve electromagnetic absorption performance within a practical range. However, when the addition amount increases, transmission loss performance is improved, but electromagnetic waves are reflected, and thus the electromagnetic absorption performance decreases. In addition, when carbon black having lower conductive performance than carbon nanotubes is used, a larger amount than that of the carbon nanotubes is required. The concentration of these electromagnetic absorbing materials in the resin composition increases, the fluidity of the resin composition decreases, and uniform electromagnetic absorption performance in the molded product may not be obtained due to poor distribution.

A method of producing the thermoplastic resin composition to be used in an electromagnetic wave absorber of the present disclosure is not particularly limited. For example, the thermoplastic resin (A) and the carbon nanotubes (B), and additionally, additives are added as necessary, and mixed using a henschel mixer, a tumbler, a disper or the like, and mixed and melt-kneaded using a kneader, a roll mill, a super mixer, a henschel mixer, a Schugi mixer, a vertical granulator, a high speed mixer, a far matrix, a ball mill, a steel mill, a sand mill, a vibration mill, an attritor, a batch type kneader such as a Banbury mixer, a twin-screw extruder, a single-screw extruder, a rotor type twin-screw kneader, and thus a resin composition in the form of pellets, powder, granules, or beads can be obtained. In the present disclosure, it is preferable to use a twin-screw extruder for melt-kneading.

The thermoplastic resin composition to be used in an electromagnetic wave absorber preferably does not contain a volatile component or contains only a small amount of a volatile component. The content of the volatile component such as a solvent and a low-molecular-weight component in 100 mass% of the thermoplastic resin composition to be used in an electromagnetic wave absorber is preferably 5 mass% or less and more preferably 1 mass% or less. In the thermoplastic resin composition of the present disclosure, when the carbon nanotubes (B) are used, the carbon nanotubes are uniformly distributed in the thermoplastic resin (A) by melt-kneading, and it is possible to form a molded article with excellent electromagnetic absorption ability with no in-plane variation.

The thermoplastic resin composition to be used in an electromagnetic wave absorber of the present disclosure contains the carbon nanotubes (B) at a relatively high concentration, and may be a masterbatch diluted with the thermoplastic resin (A) during molding, or a compound that has a relatively low concentration of the carbon nanotubes (B) and is subjected to molding without being diluted with the thermoplastic resin (A) and without changing the composition. In consideration of addition cost and inventory cost, it is preferable to use a masterbatch that can be highly concentrated. The masterbatch is preferably in the form of pellets that are easy to handle.

The content of the carbon nanotubes (B) with respect to 100 parts by mass of the thermoplastic resin (A) is preferably 0.1 to 30 parts by mass.

In the case of the masterbatch, the content of the carbon nanotubes (B) with respect to 100 parts by mass of the thermoplastic resin (A) is preferably 10 to 30 parts by mass and more preferably 10 to 25 parts by mass. If the content is 30 parts by mass or less, it is possible to inhibit re-aggregation of the carbon nanotubes and provide a masterbatch with favorable dispersibility.

In the case of the compound, the content of the carbon nanotubes (B) with respect to 100 parts by mass of the thermoplastic resin (A) is preferably 0.1 to 10 parts by mass and more preferably 0.1 to 5 parts by mass. If the content is 0.1 parts by mass or more, the electromagnetic wave absorption performance of the resin composition increases and thus the transmission loss is further improved. If the content is 10 parts by mass or less, this is preferable because the absorption performance can be improved while the reflectivity of electromagnetic waves is reduced, and better fluidity can be maintained, and thus the carbon nanotubes have favorable distribution, and uniform electromagnetic absorption performance can be obtained.

<< Molded article>>

The molded article of the present disclosure is formed from the thermoplastic resin composition to be used in an electromagnetic wave absorber and used for an electromagnetic wave absorber. The molded article can be obtained by melting and mixing a compound or masterbatch, which is the thermoplastic resin composition to be used in an electromagnetic wave absorber, and a diluent resin in a molding machine usually set at 50°C to 350°C, and then forming the shape of the molded article and performing cooling. The temperature of the molding machine is not limited as long as it is a temperature at which the thermoplastic resin (A) softens, and is preferably a temperature at least 30°C higher than the softening point of the thermoplastic resin serving as a main component. The shape of the molded article can be a plate shape, a rod shape, a fiber shape, a tube shape, a pipe shape, a bottle shape, or a film shape.

The electromagnetic wave absorber converts energy of incident electromagnetic waves into thermal energy inside the absorber and absorbs it. Unlike the electromagnetic wave shielding material, the object of the electromagnetic wave absorber is to absorb radio waves inside the molded article without reflecting radio waves on the surface of the molded article. Electromagnetic wave absorbers are used in an automatic toll collection system (ETC) for highways, in-vehicle radars, full-body scanners that see through clothes for security checks in airports and the like, millimeter-wave radar devices used for video transmission from monitoring cameras on platforms during one-man train driving, and radar false image prevention for ship masts. Particularly, the molded article formed from the thermoplastic resin composition to be used in an electromagnetic wave absorber according to the present disclosure has also excellent electromagnetic absorption performance in a millimeter-wave band with a frequency band of 60 to 90 GHz, and thus can be suitably used for millimeter-wave radar devices.

The content of the carbon nanotubes (B) of the molded article with respect to 100 parts by mass of the thermoplastic resin (A) is preferably 0.1 to 10 parts by mass and more preferably 0.1 to 5 parts by mass. If the content is 0.1 parts by mass or more, the electromagnetic wave absorption performance of the resin composition is increased, and thus the transmission loss of the molded article is further improved. If the content is 10 parts by mass or less, this is preferable because the absorption performance can be improved while the reflectivity of electromagnetic waves is reduced, and better fluidity can be maintained, and thus it is possible to obtain a molded article with favorable distribution of carbon nanotubes and uniform electromagnetic absorption performance.

In addition, as the molding method, for example, extrusion molding, injection molding, blow molding, compression molding, transfer molding, film molding such as T-die molding and inflation molding, calendar molding, spinning or the like can be used.

[Examples]

Hereinafter, the present disclosure will be described in more detail with reference to examples, but the following examples are not intended to limit the present disclosure in any way. Here, in the examples, "parts" indicates "parts by mass" and "%" indicates "mass%."

Here, the powder X-ray diffraction analysis, Raman spectroscopic analysis and volume resistivity of the carbon nanotubes, and the melting point and the molecular weight of the thermoplastic resin (A) were measured by the following methods.

<Powder X-ray diffraction analysis of carbon nanotubes>

Carbon nanotubes were placed in a central recess of an aluminum sample plate (an outer diameter of φ46 mm, a thickness of 3 mm, a sample part of φ26.5 mm, and a thickness of 2 mm) and flattened using a slide glass. Then, the surface on which the sample was placed was covered with medicine wrapping paper, and additionally, the surface on which aluminum high sheet packing was placed was flattened by applying a load of 1 ton. Then, the medicine wrapping paper and the aluminum high sheet packing were removed to obtain a carbon nanotube sample for powder X-ray diffraction analysis. Then, the carbon nanotube sample for powder X-ray diffraction analysis was placed in an X-ray diffractometer (Ultima2100, commercially available from Rigaku Corporation) and analyzed by performing operation from 15° to 35°. Sampling was performed every 0.02° and the scan speed was 2°/min. The voltage was 40 kV, the current was 40 mA, and the X-ray source was CuKα rays. Plots of the (002) plane of the carbon nanotubes appearing at a diffraction angle $2\theta=25°\pm2°$ obtained in this case were subjected to 11-point simple moving average, and the full width at half maximum of the peak was used as the full width at half maximum of the carbon nanotubes. The baseline was a line connecting plots with $2\theta=16°$ and $2\theta=34°$.

<Raman spectroscopic analysis of carbon nanotubes>

Carbon nanotubes were placed in a microscopic laser Raman spectrophotometer (NRS-3100, commercially available from JASCO Corporation) and measurement was performed using a laser wavelength of 532 nm. Measurement conditions were a fetching time of 60 seconds, a number of times of integrations of 2, a dimmer filter of 10%, an objective lens magnification of 20, a confocal hole of 500, a slit width of 100 μm, and a measurement wavelength of 100 to 3,000 $cm^{-1}$. Carbon nanotubes for measurement were dispensed on a slide glass, and flattened using a spatula. Among the obtained peaks, in the spectrum, the maximum peak intensity in a range of 1,560 to 1,600 $cm^{-1}$ was G, the maximum peak intensity in a range of 1,310 to 1,350 $cm^{-1}$ was D, and the ratio of G/D was used as the G/D ratio of carbon nanotubes.

<Volume resistivity of carbon nanotube>

Using a powder resistivity measuring device (Loresta GP powder resistivity measuring system MCP-PD-51, commercially available from Mitsubishi Chemical Analytech Co., Ltd.), with 1.2 g of a sample mass, a powder probe unit (4 probes-ring electrode, an electrode interval of 5.0 mm, an electrode radius of 1.0 mm, and a sample radius of 12.5 mm), and an applied voltage limiter of 90 V, the volume resistivity [Q.cm] of the conductive powder was measured under various pressures. The value of the volume resistivity of the carbon nanotubes at a density of 1 $g/cm^3$ was evaluated.

<Specific surface area of carbon nanotube>

0.03 g of the carbon nanotubes was weighed out using an electronic balance (MSA225S100DI, commercially available from Sartorius) and then dried at 110°C for 15 minutes while degassing. Then, the specific surface area of the carbon nanotubes was measured using a fully automatic specific surface area measuring device (commercially available from MOUNTECH, HM-model1208).

<Melting point of thermoplastic resin>

The melting peak temperature in differential scanning calorimetry (DSC) was measured using DSC6200 (commercially available from Seiko Instruments Inc.) at a heating rate of 10°C/min.

<Weight average molecular weight of thermoplastic resin>

Using a Prominence GPC system (commercially available from Shimadzu Corporation), the molecular weight distribution curve was measured by a gel permeation chromatography (GPC) method, and the weight average molecular weight (Mw) and the number average molecular weight (Mn) were calculated from polystyrene conversion values. The molecular weight distribution (Mw/Mn) was calculated from the values of the obtained weight average molecular weight and number average molecular weight. Polystyrene (commercially available from VARIAN) was used as standard polystyrene used for polystyrene conversion, TSKgelGMH-HT (commercially available from Tosoh Corporation) was used as the column, and ortho-dichlorobenzene was used as a carrier during measurement. The column temperature was 140°C, and the carrier flow rate was 1.0 mL.

Materials used in examples are as follows.

<thermoplastic resin (A)>

·(A-1) Novatec MA1B (polypropylene resin, a melting point of 165°C, a weight average molecular weight of 312,000, commercially available from Japan Polypropylene Corporation)

·(A-2) Kernel KJ-640T (polyethylene resin, a melting point of 58°C, a weight average molecular weight of 43,300, commercially available from Japan Polyethylene Corporation)

·(A-3) UBE Nylon 1030B (polyamide resin, a melting point of 225°C, a weight average molecular weight of 54,000, commercially available from Ube Industries, Ltd.)

·(A-4) DURANEX 700FP (polyester resin, a melting point of 224°C, a weight average molecular weight of 104,000, commercially available from Polyplastics Co., Ltd.)

·(A-5) Nichigo Polyester SP154 (polyester resin, a melting point of 120°C, a weight average molecular weight of 19,000, commercially available from Mitsubishi Chemical Corporation)

<Wax>

·(C-1) HI-WAX NP056 (polyethylene wax, commercially available from Mitsui Chemicals, Inc.)

·(C-2) Licowax E (polyester wax, commercially available from Clariant)

<Aliphatic metal salt>

·(D-1) magnesium stearate (aliphatic metal salt, commercially available from Tannan Kagaku Kogyo Co., Ltd.)

<Carbon nanotubes>

·(B-1) CM-130 (commercially available from Hanhwa Chemical hanos)

·(B-2) SMW210 (commercially available from SouthWest NanoTechnologies)

·(B-3) Flotube7010 (commercially available from CNano)

·(B-4) Carbon nanotubes of Production Example 1

·(B-5) Carbon nanotubes of Production Example 2

·(B-6) AMC (commercially available from Ube Industries, Ltd.)

·(B-7) Carbon nanotubes of Production Example 3

·(B'-1) Carbon nanotubes of Production Example 4

·(B'-2) Carbon nanotubes of Production Example 5

·(B'-3) Carbon nanotubes of Production Example 6

[Table 1]

| | Product name | (1) Full width at half maximum of X-ray [°] | (2) G/D ratio | Specific surface area [m$^2$/g] | Powder resistance [$\times 10^{-2}$ $\Omega \cdot$cm] |
|---|---|---|---|---|---|
| B-1 | CM-130 | 2.48 | 0.94 | 230 | 2.0 |
| B-2 | SMW210 | 3.98 | 1.03 | 300 | 1.9 |
| B-3 | Flotube7010 | 5.24 | 1.23 | 450 | 1.5 |
| B-4 | Production Example 1 | 2.32 | 0.50 | 230 | 2.3 |
| B-5 | Production Example 2 | 2.30 | 2.00 | 230 | 1.5 |

(continued)

|  | Product name | (1) Full width at half maximum of X-ray [°] | (2) G/D ratio | Specific surface area [m²/g] | Powder resistance [×10⁻² Ω·cm] |
|---|---|---|---|---|---|
| B-6 | AMC | 2.50 | 0.94 | 230 | 3.0 |
| B-7 | Production Example 3 | 5.50 | 0.73 | 680 | 1.7 |
| B'-1 | Production Example 4 | 1.50 | 0.92 | 210 | 1.2 |
| B'-2 | Production Example 5 | 6.20 | 1.53 | 400 | 1.6 |
| B'-3 | Production Example 6 | 2.20 | 2.33 | 200 | 1.9 |

(Production Example 1: B-4)

<Catalyst for synthesizing carbon nanotubes (B-4)>

60 parts by mass of cobalt hydroxide, 138 parts by mass of magnesium acetate tetrahydrate, 16.2 parts by mass of manganese carbonate, and 4.0 parts by mass of silicon oxide ($SiO_2$, commercially available from Nippon Aerosil Co., Ltd.: AEROSIL (registered trademark) 200) were weighed out into a heat-resistant container, dried using an electric oven at a temperature of 170±5°C for 1 hour to evaporate water, and then pulverized for 1 minute using a pulverizer (Wonder crusher WC-3, commercially available from OSAKA CHEMICAL Co., Ltd.) by adjusting the SPEED dial to 3. Then, each pulverized powder was mixed using the pulverizer (Wonder crusher WC-3, commercially available from OSAKA CHEMICAL Co., Ltd.) for 30 seconds by adjusting the SPEED Dial to 2 to produce a catalyst precursor for synthesizing carbon nanotubes (B-4). Then, the catalyst precursor for synthesizing carbon nanotubes (B-4) was transferred to a heat-resistant container and fired using a muffle furnace (FO510, commercially available from Yamato Scientific Co., Ltd.) for 30 minutes under conditions of an air atmosphere and 450±5°C, and then pulverized in a mortar to obtain a catalyst for synthesizing carbon nanotubes (B-4).

<Synthesis of carbon nanotubes (B-4)>

A quartz glass heat-resistant dish on which 2 g of the catalyst for synthesizing carbon nanotubes (B-4) was dispersed was placed in the center of a horizontal reaction tube having an internal volume of 10 L, which could be pressurized and heated by an external heater. Exhaustion was performed while injecting nitrogen gas, the air in the reaction tube was replaced with nitrogen gas, and the atmosphere in the horizontal reaction tube was made to have an oxygen concentration of 1 volume% or less. Then, heating was performed in the external heater until the temperature in the center in the horizontal reaction tube reached 680°C. After the temperature reached 680°C, propane gas as a carbon source was introduced into the reaction tube at a flow rate of 2 L/min and a contact reaction was performed for 1 hour. After the reaction was completed, the gas in the reaction tube was replaced with nitrogen gas, cooling was performed until the temperature of the reaction tube reached 100°C or lower, and removal was performed to obtain carbon nanotubes (B-4).

(Production Example 2: B-5)

<Synthesis of carbon nanotubes (B-5)>

10 kg of the carbon nanotubes (B-1) was weighed out in a 120 L heat-resistant container, and the heat-resistant container containing the carbon nanotubes (B-1) was placed in a furnace. Then, nitrogen gas was introduced into the furnace, and air in the furnace was discharged while maintaining a positive pressure. After the oxygen concentration in the furnace became 0.1% or less, heating was performed to 1,600°C over 30 hours. While maintaining the temperature in the furnace at 1,600°C, chlorine gas was introduced at a rate of 50 L/min for 50 hours. Then, nitrogen gas was introduced at 50 L/min to perform cooling while maintaining a positive pressure, and thereby carbon nanotubes (B-5) were obtained.

(Production Example 3: B-7)

<Synthesis of carbon nanotubes (B-7)>

10 kg of the carbon nanotubes (B-1) was weighed out in a 120 L heat-resistant container, and the heat-resistant container containing the carbon nanotubes (B-1) was placed in a furnace. Then, exhaustion was performed while injecting nitrogen gas, the air in the reaction tube was replaced with nitrogen gas, and heating was performed until the atmosphere temperature in the horizontal reaction tube reached 700°C. After the temperature reached 700°C, ethylene gas as a hydrocarbon was introduced into the reaction tube at a flow rate of 2 L/min and a contact reaction was performed for 15 minutes. After the reaction was completed, the gas in the reaction tube was replaced with nitrogen gas, cooling was performed until the temperature of the reaction tube reached 100°C or lower, and removal was performed to obtain carbon nanotubes (B-7).

(Production Example 4: B' -1)

<Catalyst for synthesizing carbon nanotubes (B'-1)>

200 g of cobalt acetate tetrahydrate, 2.4 g of manganese metal, and 172 g of magnesium acetate tetrahydrate as a supporting component were weighed out into a beaker, 1,488 g of water was added, and the mixture was stirred until it became uniform. The sample was transferred to a heat-resistant container, dried using an electric oven at a temperature of $190 \pm 5$°C for 30 minutes to evaporate water, and then pulverized in a mortar to obtain a catalyst precursor for synthesizing carbon nanotubes (B'-1). 400 g of the obtained catalyst precursor for synthesizing carbon nanotubes (B'-1) was weighed out into a heat-resistant container, fired in a muffle furnace for 30 minutes under atmospheres of air and $500°C \pm 5$°C, and then pulverized in a mortar to obtain a catalyst for synthesizing carbon nanotubes (B'-1).

<Synthesis of carbon nanotubes (B'-1)>

A quartz glass heat-resistant dish on which 1.0 g of the catalyst for synthesizing carbon nanotubes (B'-1) was dispersed was placed in the center of a horizontal reaction tube having an internal volume of 10 L, which could be pressurized and heated by an external heater. Exhaustion was performed while injecting argon gas, the air in the reaction tube was replaced with argon gas, and the atmosphere in the horizontal reaction tube was made to have an oxygen concentration of 1 volume% or less. Then, heating was performed in the external heater until the temperature in the center in the horizontal reaction tube reached 700°C. After the temperature was reached 700°C, hydrogen gas was introduced into the reaction tube at a flow rate of 0.1 L/min for 1 minute, and the catalyst was activated. Then, ethanol as a carbon source was introduced into the reaction tube at a flow rate of 1 L/min and a contact reaction was performed for 4 hours. After the reaction was completed, the gas in the reaction tube was replaced with argon gas, cooling was performed until the temperature in the reaction tube reached 100°C or lower, and the obtained carbon nanotubes were collected. The obtained carbon nanotubes were pulverized and filtered through an 80-mesh wire mesh in order to compare the conductivity and dispersibility.

(Production Example 5: B'-2)

<Catalyst for synthesizing carbon nanotubes (B'-2)>

1,000 parts by mass of magnesium acetate tetrahydrate was weighed out into a heat-resistant container and dried using an electric oven at an atmosphere temperature of $170 \pm 5$°C for 6 hours and then pulverized using a pulverizer (sample mill KIIW-I type, commercially available from Dulton Co., Ltd.) by mounting a 1 mm screen and thereby a dried magnesium acetate pulverized product was obtained. 45.8 parts of the dried magnesium acetate pulverized product, 8.1 parts of manganese carbonate, 1.0 part of silicon oxide ($SiO_2$, AEROSIL (registered trademark) 200 commercially available from Nippon Aerosil Co., Ltd.), and 200 parts of steel beads (a bead diameter of 2.0 mmφ) were put into an SM sample bottle (commercially available from Sansyo Co., Ltd.) and pulverized and mixed using a paint conditioner (commercially available from Red Devil) for 30 minutes. Then, a stainless steel sieve was used to separate the pulverized and mixed powder and steel beads (a bead diameter of 2.0 mmφ) to obtain a catalyst support for synthesizing carbon nanotubes (B'-2). Then, 30 parts by mass of cobalt(II) hydroxide was weighed out into a heat-resistant container and dried at an atmosphere temperature of $170 \pm 5$°C for 2 hours to obtain a cobalt composition containing $CoHO_2$. After that, 54.9 parts by mass of the catalyst support for synthesizing carbon nanotubes (B'-2) and 29 parts by mass of the cobalt composition were put into a pulverizer (Wonder crusher WC-3, commercially available from OSAKA CHEMICAL Co., Ltd.), a standard lid was mounted, the SPEED Dial was adjusted to 2, and the sample was pulverized and mixed for 30 seconds to obtain a catalyst precursor for synthesizing carbon nanotubes (B'-2). The catalyst precursor for synthesizing carbon nanotubes (B'-2) was transferred to a heat-resistant container and fired using a muffle furnace (FO510, commercially available from Yamato Scientific Co., Ltd.) for 30 minutes under conditions of an air atmosphere and 450±5°C and then pulverized in a mortar to obtain a catalyst for synthesizing carbon nanotubes (B'-2).

<Synthesis of carbon nanotubes (B'-2)>

A quartz glass heat-resistant dish on which 1 g of the catalyst for synthesizing carbon nanotubes (B'-2) was dispersed was placed in the center of a horizontal reaction tube having an internal volume of 10 L, which could be pressurized and heated by an external heater. Exhaustion was performed while injecting nitrogen gas, the air in the reaction tube was replaced with nitrogen gas, and heating was performed until the atmosphere temperature in the horizontal reaction tube reached 680°C. After the temperature reached 680°C, ethylene gas as a hydrocarbon was introduced into the reaction tube at a flow rate of 2 L/min and a contact reaction was performed for 7 minutes. After the reaction was completed, the gas in the reaction tube was replaced with nitrogen gas, cooling was performed until the temperature of the reaction tube reached 100°C or lower, and removal was performed to obtain a carbon nanotube (B'-2) precursor. 1,000 g of the carbon nanotube (B'-2) precursor was weighed out into a heat-resistant container made of carbon. Then, the heat-resistant container made of carbon containing the carbon nanotube (B'-2) precursor was placed in a furnace. Then, the inside of the furnace was vacuum-exhausted to 1 Torr (133 Pa) or less, and additionally, a current was applied to a carbon heater, and the inside of the furnace was heated to 1,000°C. Next, argon gas was introduced into the furnace, the pressure in the furnace was adjusted to 70 Torr (9.33 kPa), and argon gas at 1 L/min was then introduced into the furnace. Then, in addition to argon gas, chlorine gas was introduced, the pressure in the furnace was adjusted to 90 Torr (11.99 kPa), and after the pressure reached, chlorine gas at 0.3 L/min was introduced into the furnace. After the state was maintained for 1 hour, current application was stopped, introduction of argon gas and chlorine gas was stopped, and vacuum-cooling was performed. Finally, after vacuum-cooling was performed at a pressure of 1 Torr (133 Pa) or less for 12 hours, it was confirmed that the inside of the furnace was cooled to room temperature, and nitrogen gas was then introduced into the furnace until the pressure reached atmospheric pressure, and the heat-resistant container was taken out to obtain carbon nanotubes (B'-2).

(Production Example 6: B'-3)

<Synthesis of carbon nanotubes (B'-3)>

10 kg of the carbon nanotubes (B-1) was weighed out in a 120 L heat-resistant container, and the heat-resistant container containing the carbon nanotubes (B-1) was placed in a furnace. Then, nitrogen gas was introduced into the furnace, and air in the furnace was discharged while maintaining a positive pressure. After the oxygen concentration in the furnace became 0.1% or less, heating was performed to 1,800°C over 30 hours. While maintaining the temperature in the furnace at 1,800°C, chlorine gas was introduced at a rate of 50 L/min for 50 hours. Then, nitrogen gas was introduced at 50 L/min to perform cooling while maintaining a positive pressure, and thereby carbon nanotubes (B'-3) were obtained.

(Example 1)

(Production of thermoplastic resin composition to be used in electromagnetic wave absorber)

88% of the thermoplastic resin (A-1), 3% of the carbon nanotubes (B-1), and 9% of the dispersant (C-1) were mixed and melt-kneaded, the mixture was extruded using a twin-screw extruder (commercially available from The Japan Steel Works, Ltd.) at 230°C and granulated to obtain a thermoplastic resin composition to be used in an electromagnetic wave absorber.

(Production of molded article)

The obtained thermoplastic resin composition to be used in an electromagnetic wave absorber was molded using an injection molding machine (commercially available from Toshiba Machine Co., Ltd.) at a cylinder set temperature of 220°C and a mold temperature of 40°C to produce a molded article of length 90 mm×width 110 mm×thickness 4 mm.

(Examples 2 to 13)

Thermoplastic resin compositions to be used in an electromagnetic wave absorber and molded articles were obtained in the same method as in Example 1 except that materials and blending amounts (parts by mass) were changed as shown in Table 2. Here, in Examples 10 to 12, the mixture was extruded using a twin-screw extruder (commercially available from The Japan Steel Works, Ltd.) at 250°C to produce a thermoplastic resin composition to be used in an electromagnetic wave absorber, and a molded article was produced using an injection molding machine (commercially available from Toshiba Machine Co., Ltd.) at a cylinder set temperature of 250°C and a mold temperature of 80°C.

(Example 14)

(Production of thermoplastic resin composition to be used in electromagnetic wave absorber (masterbatch))

55% of the thermoplastic resin (A-1), 15% of the carbon nanotubes (B-1), and 30% of the dispersant (C-1) were mixed and melt-kneaded, the mixture was extruded using a twin-screw extruder (commercially available from The Japan Steel Works, Ltd.) at 230°C and granulated to obtain a masterbatch of a thermoplastic resin composition to be used in an electromagnetic wave absorber.

(Production of molded article)

The obtained masterbatch of the thermoplastic resin composition to be used in an electromagnetic wave absorber was diluted with the thermoplastic resin (A-1) so that the proportion of the carbon nanotubes (B-1) was 3%, and molded using an injection molding machine (commercially available from Toshiba Machine Co., Ltd.) at a cylinder set temperature of 220°C and a mold temperature of 40°C to produce a molded article of length 90 mm×width 110 mm×thickness 4 mm.

(Comparative Example 1)

80% of the thermoplastic resin (A-1), 5% of the carbon nanotubes (B-1), and 15% of the dispersant (C-1) were mixed and melt-kneaded, and the mixture was extruded using a single-screw extruder (commercially available from The Japan Steel Works, Ltd.) at 230°C and granulated to obtain a thermoplastic resin composition to be used in an electromagnetic wave absorber.

(Production of molded article)

The obtained thermoplastic resin composition to be used in an electromagnetic wave absorber was molded using an injection molding machine (commercially available from Toshiba Machine Co., Ltd.) at a cylinder set temperature of 220°C and a mold temperature of 40°C to produce a molded article of length 90 mm×width 110 mm×thickness 4 mm.

(Comparative Example 2)

A thermoplastic resin composition to be used in an electromagnetic wave absorber and a molded article were obtained in the same method as in Comparative Example 1 except that materials and blending amounts (parts by mass) were changed as shown in Table 3. Here, the mixture was extruded using a twin-screw extruder (commercially available from The Japan Steel Works, Ltd.) at 250°C to produce a thermoplastic resin composition to be used in an electromagnetic wave absorber and a molded article was produced using an injection molding machine (commercially available from Toshiba Machine Co., Ltd.) at a cylinder set temperature of 250°C and a mold temperature of 80°C.

(Comparative Example 3)

80% of the thermoplastic resin (A-1), 5% of the carbon nanotubes (B-1), and 15% of the dispersant (C-1) were mixed and melt-kneaded, the mixture was extruded using a twin-screw extruder (commercially available from The Japan Steel Works, Ltd.) at 230°C and granulated to obtain a thermoplastic resin composition to be used in an electromagnetic wave absorber.

(Production of molded article)

The obtained thermoplastic resin composition to be used in an electromagnetic wave absorber was molded using an injection molding machine (commercially available from Toshiba Machine Co., Ltd.) at a cylinder set temperature of 220°C and a mold temperature of 40°C to produce a molded article of length 90 mm×width 110 mm×thickness 4 mm.

(Comparative Examples 4 to 6)

Thermoplastic resin compositions to be used in an electromagnetic wave absorber and molded articles were obtained in the same method as in Comparative Example 3 except that materials and blending amounts (parts by mass) were changed as shown in Table 1.

Physical property values and evaluation results of the obtained thermoplastic resin compositions were obtained by the following methods. The results are shown in Table 4.

<Measurement of sheet surface maximum height Sz>

A sheet having a thickness of 100 $\mu$m was produced by using a T-die molding machine at a temperature 30°C higher than the melting point of the thermoplastic resin (A) used as a main component in the resin composition. Using the obtained sheet, the maximum height Sz ($\mu$m) was measured with a measurement length of 2.5 mm$\times$2.5 mm and a robust Gaussian filter of 0.08 mm using TalySurf CCI MP-HS (commercially available from Taylor/Hobson).

(Electromagnetic absorption performance)

As an index of electromagnetic absorption performance, the reflection loss and transmission loss (dB) in the millimeter wave frequency band were measured by the following method. Using E8257D+E8257DS12 (output: 4 dBm) as a millimeter wave transmitter, N9030A+M1970V as a millimeter wave receiver, and AAHR015 (WR15, AET, INC) (all commercially available from Keysight Technologies) as a horn antenna, in an environment with a temperature of 24.8°C and a relative humidity of 48%, for the molded articles obtained in examples and comparative examples, the reflection loss and transmission loss at a measurement frequency of 77 GHz were measured. The electromagnetic absorption performance was evaluated based on the following criteria.

[Evaluation criteria]

A: the reflection loss was -8 dB or less, and the transmission loss was -15 dB or less
B: the reflection loss was -5 dB or less, and the transmission loss was -10 dB or less
C: the reflection loss was larger than -5 dB, or the transmission loss was larger than -10 dB

(In-plane variation)

The fluidity was measured and evaluated by the following method from the transmission loss (dB) in the millimeter wave frequency band at four corners of the molded article based on the in-plane variation. Using E8257D+E8257DS12 (output: 4 dBm) as a millimeter wave transmitter, N9030A+M1970V as a millimeter wave receiver, and AAHR015 (WR15, AET, INC) (all commercially available from Keysight Technologies) as a horn antenna, in an environment with a temperature of 24.8°C and a relative humidity of 48%, for the molded articles obtained in examples and comparative examples, the transmission loss at a measurement frequency of 77 GHz was measured. The fluidity was evaluated based on the following criteria.

[Evaluation criteria]

A: the difference between the maximum value and the minimum value of the transmission loss at four corners of the molded article was 1 dB or less
B: the difference between the maximum value and the minimum value of the transmission loss at four corners of the molded article was more than 1 dB and 3 dB or less
C: the difference between the maximum value and the minimum value of the transmission loss at four corners of the molded article was more than 3 dB

[Table 2]

| | | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Thermoplastic resin | A-1 | 88 | 97 | 88 | 88 | 88 | 88 | 88 | 88 | 88 | |
| | A-2 | | | | | | | | | 9 | |
| | A-3 | | | | | | | | | | 88 |
| | A-4 | | | | | | | | | | |
| | A-5 | | | | | | | | | | |
| Carbon nanotubes | B-1 | 3 | 3 | | | | | | | 3 | 3 |
| | B-2 | | | 3 | | | | | | | |
| | B-3 | | | | 3 | | | | | | |
| | B-4 | | | | | 3 | | | | | |
| | B-5 | | | | | | 3 | | | | |
| | B-6 | | | | | | | 3 | | | |
| | B-7 | | | | | | | | 3 | | |
| | B'-1 | | | | | | | | | | |
| | B'-2 | | | | | | | | | | |
| | B'-3 | | | | | | | | | | |
| Wax | C-1 | 9 | | 9 | 9 | 9 | 9 | 9 | 9 | | |
| | C-2 | | | | | | | | | | 9 |
| Aliphatic metal salt | D-1 | | | | | | | | | | |
| CNT content [parts]/100 parts of thermoplastic resin | | 3.4 | 3.1 | 3.4 | 3.4 | 3.4 | 3.4 | 3.4 | 3.4 | 3.1 | 3.4 |
| Surface roughness maximum height Sz | | 3.2 | 4.9 | 3.5 | 3.8 | 3.8 | 3.8 | 3.6 | 4.0 | 4.0 | 3.2 |

[Table 3]

| | | Example 11 | Example 12 | Example 13 | Example 14 | Comparative Example 1 | Comparative Example 2 | Comparative Example 3 | Comparative Example 4 | Comparative Example 5 | Comparative Example 6 |
|---|---|---|---|---|---|---|---|---|---|---|---|
| Thermoplastic resin | A-1 | | | 88 | 91 | 97 | | 88 | 88 | 88 | 70 |
| | A-2 | | | | | | | | | | |
| | A-3 | 88 | | | | | 97 | | | | |
| | A-4 | | 88 | | | | | | | | |
| | A-5 | 9 | 9 | | | | | | | | |
| Carbon nanotubes | B-1 | 3 | 3 | 3 | 3 | 3 | 3 | | | 3 | 15 |
| | B-2 | | | | | | | | | | |
| | B-3 | | | | | | | | | | |
| | B-4 | | | | | | | | | | |
| | B-5 | | | | | | | | | | |
| | B-6 | | | | | | | | | | |
| | B-7 | | | | | | | | | | |
| | B'-1 | | | | | | | 3 | | | |
| | B'-2 | | | | | | | | 3 | | |
| | B'-3 | | | | | | | | | 3 | |
| Wax | C-1 | | | | 6 | | | 9 | 9 | 9 | 15 |
| | C-2 | | | | | | | | | | |
| Aliphatic metal salt | D-1 | | | 9 | | | | | | | |
| CNT content [parts]/100 parts of thermoplastic resin | | 3.1 | 3.1 | 3.4 | 3.3 | 3.1 | 3.1 | 3.4 | 3.4 | 3.4 | 21.4 |
| Surface roughness maximum height Sz | | 4.0 | 4.0 | 3.6 | 3.4 | 10.0 | 10.0 | 4.1 | 5.0 | 4.7 | 9.3 |

[Table 4]

| | Carbon nanotubes | Radio wave absorption performance | | | |
|---|---|---|---|---|---|
| | | Reflection loss | Transmission loss | Overall evaluation | In-plane variation |
| Example 1 | B-1 | -10 | -17 | A | A |
| Example 2 | B-2 | -9 | -10 | B | B |
| Example 3 | B-3 | -7 | -15 | B | A |
| Example 4 | B-4 | -8 | -14 | B | A |
| Example 5 | B-5 | -8 | -14 | A | A |
| Example 6 | B-6 | -8 | -14 | B | A |
| Example 7 | B-6 | -9 | -12 | A | A |
| Example 8 | B-7 | -7 | -12 | B | B |
| Example 9 | B-1 | -8 | -16 | A | A |
| Example 10 | B-1 | -8 | -17 | A | A |
| Example 11 | B-1 | -8 | -15 | A | A |
| Example 12 | B-1 | -8 | -15 | A | A |
| Example 13 | B-1 | -8 | -15 | A | A |
| Example 14 | B-1 | -9 | -16 | A | A |
| Comparative Example 1 | B-1 | -5 | -5 | C | C |
| Comparative Example 2 | B-1 | -5 | -5 | C | C |
| Comparative Example 3 | B'-1 | -7 | -7 | C | B |
| Comparative Example 4 | B'-2 | -7 | -9 | C | B |
| Comparative Example 5 | B'-3 | -7 | -7 | C | B |
| Comparative Example 6 | B-1 | -1 | -20 | C | C |

Based on the evaluation results, it was confirmed that the thermoplastic resin composition to be used in an electromagnetic wave absorber of the present disclosure and the molded article using the same had a high reflection loss and transmission loss in a specific frequency band of 60 to 90 GHz. In addition, it was confirmed that the composition had high fluidity, and the molded article using the composition had uniform electromagnetic absorption performance with no in-plane variation. It can be said that the composition and the molded article using the same can be used not only for general electromagnetic wave absorbers but also suitably for radar devices for which millimeter wave absorption is required.

Priority is claimed on Japanese Patent Application No. 2021-074629, filed April 27, 2021, the content of which is incorporated herein by reference.

## Claims

1. A thermoplastic resin composition which is to be used in an electromagnetic wave absorber and contains a thermoplastic resin (A) and carbon nanotubes (B),

wherein the carbon nanotubes (B) satisfy the following (1) and (2), and
wherein a sheet having a thickness of 100 $\mu$m and formed from the thermoplastic resin composition has a sheet surface maximum height Sz of 5 $\mu$m or less, which is measured according to ISO 25178:

> (1) the full width at half maximum of the diffraction peak of the (002) plane in powder X-ray diffraction analysis is 2.0° to 6.0°.
> (2) the ratio (G/D ratio) of the maximum peak intensity G in a range of 1,560 to 1,600 $cm^{-1}$ and the maximum peak intensity D in a range of 1,310 to 1,350 $cm^{-1}$ in a Raman spectrum is 0.5 to 2.0.

2. The thermoplastic resin composition to be used in an electromagnetic wave absorber according to claim 1, wherein the carbon nanotubes (B) have a BET specific surface area of 200 to 600 $m^2/g$.

3. The thermoplastic resin composition to be used in an electromagnetic wave absorber according to claim 1 or 2, wherein the carbon nanotubes (B) have a volume resistivity of $1.0 \times 10^{-3}$ to $3.0 \times 10^{-2}$ $\Omega \cdot cm$.

4. The thermoplastic resin composition to be used in an electromagnetic wave absorber according to any one of claims 1 to 3, further containing at least one of a wax and an aliphatic metal salt.

5. The thermoplastic resin composition to be used in an electromagnetic wave absorber according to any one of claims 1 to 4,
wherein the thermoplastic resin (A) contains one selected from the group consisting of a polyethylene resin, a polypropylene resin, an acrylonitrile-butadienestyrene copolymer resin, a polycarbonate resin, a polyamide resin, and a polyester-based resin.

6. A molded article formed from the thermoplastic resin composition to be used in an electromagnetic wave absorber according to any one of claims 1 to 5.

| | INTERNATIONAL SEARCH REPORT | International application No. |
|---|---|---|
| | | **PCT/JP2022/018608** |

**A. CLASSIFICATION OF SUBJECT MATTER**

*H05K 9/00*(2006.01)i; *C08L 101/00*(2006.01)i

FI: H05K9/00 X; C08L101/00

According to International Patent Classification (IPC) or to both national classification and IPC

**B. FIELDS SEARCHED**

Minimum documentation searched (classification system followed by classification symbols)

H05K9/00; C08L101/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2015-029220 A (SHACHIHATA INC) 12 February 2015 (2015-02-12) <br> paragraph [0040] | 1-6 |
| Y | WO 2019/235561 A1 (MICROWAVE ABSORBERS INC.) 12 December 2019 (2019-12-12) <br> paragraphs [0001], [0021]-[0028], [0040] | 1-6 |
| Y | JP 2010-209162 A (TOYO INK MFG CO LTD) 24 September 2010 (2010-09-24) <br> paragraphs [0029], [0037]-[0038] | 1-6 |

☐ Further documents are listed in the continuation of Box C.    ☑ See patent family annex.

| | |
|---|---|
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **07 July 2022** | **19 July 2022** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**
Information on patent family members

International application No.

**PCT/JP2022/018608**

| Patent document<br>cited in search report | | | Publication date<br>(day/month/year) | Patent family member(s) | Publication date<br>(day/month/year) |
|---|---|---|---|---|---|
| JP | 2015-029220 | A | 12 February 2015 | (Family: none) | |
| WO | 2019/235561 | A1 | 12 December 2019 | (Family: none) | |
| JP | 2010-209162 | A | 24 September 2010 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016108524 A
- JP 2017512847 W
- JP 2016504471 W
- JP 2021074629 A